# FASCICULE DE BREVET EUROPEEN

(11) **EP 2 655 058 B1**
(45) Date de publication et mention de la délivrance du brevet: **18.01.2017**
(21) Numéro de dépôt: 11794825.7
(22) Date de dépôt: 17.11.2011
(51) Int. Cl.: B32B 27/06, H01L 31/00, H01L 31/048, C08G 81/02

(54) **ENCAPSULANT D'UN MODULE PHOTOVOLTAÏQUE**
EINBETTUNGSSCHICHT EINES PHOTOVOLTAIKMODULS
ENCAPSULANT OF A PHOTOVOLTAIC MODULE

(30) Priorité: 23.12.2010 FR 1061150
(43) Date de publication de la demande: 30.10.2013
(73) Titulaire: Arkema France, 92700 Colombes (FR)
(72) Inventeur: BIZET, Stéphane, F-27170 Barc (FR); DEVISME, Samuel, F-76000 Rouen (FR); FINE, Thomas, F-69007 Lyon (FR); JOUSSET, Dominique, F-27470 Serquigny (FR)
(74) Mandataire: Kling, Simone
(86) Numéro de dépôt international: PCT/FR2011/052674
(87) Numéro de publication internationale: WO 2012/085369

(56) Documents cités:
- EP-A1- 0 990 515
- EP-A1- 2 196 489
- WO-A-02/28959
- WO-A-2008/043958
- WO-A1-2009/138679
- FR-A- 2 882 060
- FR-A1- 2 891 490

## Description

### Domaine de l'invention

L'invention a pour objet un encapsulant de module photovoltaïque présentant une structure coeur-peau particulière lui conférant des propriétés optimums pour cette application. La présente invention concerne également un module photovoltaïque comprenant, outre la couche d'encapsulant, au moins une couche adjacente formant « frontsheet » ou « backsheet », plus généralement ces trois couches successives, « frontsheet », encapsulant et « backsheet ».

Le réchauffement climatique, lié aux gaz à effet de serre dégagés par les énergies fossiles, a mené au développement de solutions énergétiques alternatives qui n'émettent pas de tels gaz lors de leur fonctionnement, comme par exemple les modules photovoltaïques. Un module photovoltaïque comprend une « pile photovoltaïque », cette pile étant capable de transformer l'énergie lumineuse en électricité.

Il existe de nombreux types de structures de panneaux photovoltaïques.

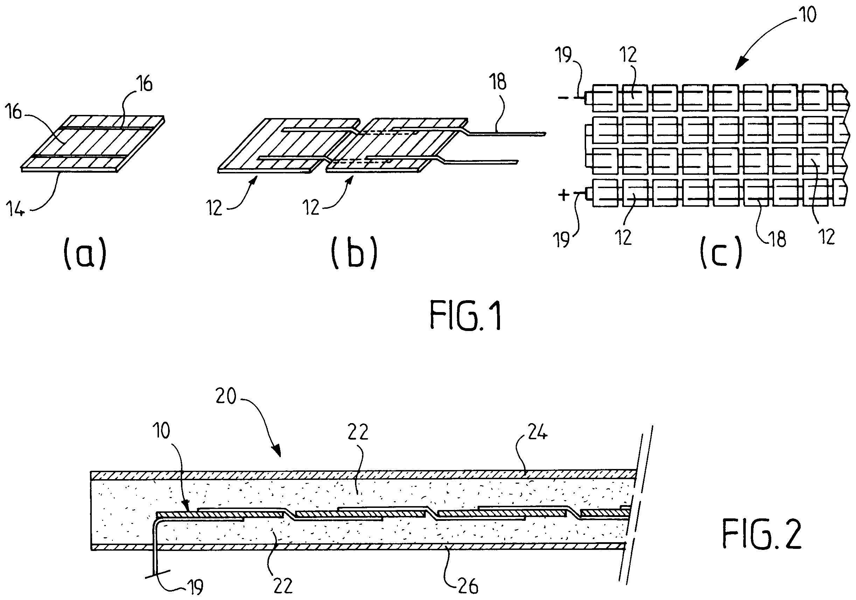

Sur la Figure 1, on a représenté une pile photovoltaïque classique ; cette pile photovoltaïque 10 comprend des cellules 12, une cellule contenant un capteur photovoltaïque 14, généralement à base de silicium traité afin d'obtenir des propriétés photoélectriques, en contact avec des collecteurs d'électrons 16 placés au-dessus (collecteurs supérieurs) et au-dessous (collecteurs inférieurs) du capteur photovoltaïque. Les collecteurs 16 supérieurs d'une cellule sont reliés aux collecteurs 16 inférieurs d'une autre cellule 12 par des barres conductrices 18, constituées généralement d'un alliage de métaux. Toutes ces cellules 12 sont connectées entre elles, en série et/ou en parallèle, pour former la pile photovoltaïque 10. Lorsque la pile photovoltaïque 10 est placée sous une source lumineuse, elle délivre un courant électrique continu, qui peut être récupéré aux bornes 19 de la pile 10.

En référence à la Figure 2, le module photovoltaïque 20 comprend la pile photovoltaïque 10 de la Figure 1 enrobée dans un « encapsulant », celui-ci étant composé d'une partie supérieure 22 et d'une partie inférieure 23. Une couche protectrice supérieure 24 (connue en anglais sous le terme « frontsheet », utilisé dans la suite) et une couche protectrice au dos du module (connue en anglais sous le terme « backsheet », également utilisé dans la suite) 26 sont disposées de part et d'autre la pile encapsulée.

La protection au choc et à l'humidité de la pile photovoltaïque 10 est assurée par la couche protectrice supérieure 24, généralement en verre.

Le backsheet 26, par exemple un film multicouche à base de polymère fluoré et de polyéthylène téréphtalate, contribue à la protection à l'humidité du module photovoltaïque 20 et à l'isolation électrique des cellules 12 pour éviter tout contact avec l'environnement extérieur.

L'encapsulant 22 et 23 doit épouser parfaitement la forme de l'espace existant entre la pile photovoltaïque 10 et les couches protectrices 24 et 26 afin d'éviter la présence d'air, ce qui limiterait le rendement du module photovoltaïque. L'encapsulant 22 et 23 doit également empêcher le contact des cellules 12 avec l'eau et l'oxygène de l'air, afin d'en limiter la corrosion. La partie supérieure 22 de l'encapsulant est comprise entre la pile 10 et la couche protectrice supérieure 24. La partie inférieure 23 de l'encapsulant est comprise entre la pile 10 et le backsheet 26. Dans une variante de réalisation de l'encapsulant, il n'existe pas de partie inférieure ou supérieure de sorte que les cellules 12 de la pile se trouvent en contact avec respectivement le backsheet 26 ou le frontsheet 24. Cette variante est illustrée sur la figure 3 où l'on voit la cellule photovoltaïque 12 en contact direct avec le frontsheet 24 et est décrite plus en détails notamment dans la demande WO99/04971.

En présence de rayonnement solaire, il se crée un échauffement à l'intérieur du module solaire et des températures de 80°C (ou plus) peuvent être atteintes. Les propriétés thermomécaniques, et en particulier la tenue au fluage, de l'adhésif, du liant ou de l'encapsulant doivent donc être conservées à ces températures pour que celui-ci ne soit pas déformé. La tenue au fluage est plus particulièrement importante dans le cas de l'encapsulant : en effet, en cas de fluage, la pile peut rentrer en contact avec l'air et/ou les couches protectrices supérieure et/ou inférieure, ce qui entraîne une diminution du rendement du module solaire, voire une dégradation de la pile et du module solaire. En outre, l'encapsulant peut présenter de bonnes propriétés ignifuges (au moins un classement V2 selon les tests conformes au classement UL94).

De plus, pour ne pas diminuer le rendement du module solaire, il est nécessaire que l'encapsulant permette la transmission des ondes lumineuses du rayonnement solaire vers les cellules (indice de réfraction satisfaisant) et présente une bonne résistance aux UVs. Toujours pour ne pas diminuer le rendement, il est souhaitable que ces ondes lumineuses soient peu diffractées, c'est-à-dire que l'encapsulant doit être, à l'oeil nu, transparent ou légèrement translucide, la transparence étant quantifiée par son « niveau de trouble » ou encore « Haze », qui doit être faible et sa transmittance qui doit être la plus élevée possible. Bien entendu, ces considérations relatives à la transparence de l'encapsulant sont à vérifier pour la partie de celui-ci situé au-dessus des cellules photovoltaïques, de sorte que pour la partie inférieure, il n'est pas forcément nécessaire que l'encapsulant présente de telles propriétés.

Il est nécessaire également que l'encapsulant ait de bonnes propriétés d'isolation électrique, afin d'éviter tout court-circuit à l'intérieur du module.

Ainsi, dans les applications d'encapsulant ou d'encapsulant-backsheet pour les modules photovoltaïques, les matériaux ou compositions doivent impérativement présenter une parfaite transparence afin d'autoriser la transmission sans perte (ou à minima) du rayonnement lumineux. Par ailleurs, ce matériau/composition thermoplastique doit présenter une bonne tenue mécanique, en particulier vis-à-vis des propriétés de résistance à l'allongement à la rupture et à la contrainte à la rupture, ainsi que de bonnes propriétés thermomécaniques, en particulier vis-à-vis du test de fluage à chaud, compte tenu de l'échauffement du module photovoltaïque lors d'une exposition prolongée au soleil. Enfin, ce matériau/composition thermoplastique doit également présenter un bon niveau de résistance au feu (ignifugation).

Une caractéristique essentielle pour un encapsulant est également sa capacité à adhérer sur divers supports (notamment verres, différents polymères et compositions thermoplastiques) et ceci quelque soient les conditions d'environnement, en particulier au regard des conditions de température et en atmosphère humide.

De plus, l'encapsulant doit présenter la meilleure imperméabilité possible à l'eau et à l'oxygène pour éviter tout risque de corrosion/oxydation des cellules électriques conductrices, souvent en métal corrodable.

Enfin, l'encapsulant doit être facilement mis en oeuvre lors de l'étape de lamination du panneau/module photovoltaïque. La fonction première d'un encapsulant vise à enrober la pile électrique et il est donc nécessaire que l'encapsulant dispose d'excellentes propriétés d'isolation électrique.

Enfin, dans certains cas, ce matériau/composition thermoplastique peut également présenter un bon niveau de résistance au feu (ignifugation).

Au regard de l'ensemble des propriétés que doit rassembler un encapsulant de module photovoltaïque, on comprend qu'il est particulièrement difficile de disposer d'une telle structure présentant toutes ces propriétés, étant considéré que l'homme du métier sait que l'amélioration de certaines de ces propriétés s'obtient au détriment d'autres, par exemple l'obtention de bonnes propriétés d'imperméabilité à l'eau se fait au détriment de la transparence et de la souplesse de l'encapsulant.

A l'heure actuelle, il n'existe pas sur le marché d'encapsulant de module photovoltaïque présentant un encapsulant consistant en une composition thermoplastique de type coeur-peau présentant des propriétés satisfaisantes au niveau de l'ensemble des propriétés susmentionnées, à savoir des propriétés optiques particulières (transparence, faible niveau de Haze et d'indice de réfraction), une parfaite adhésion sur différents supports, une bonne tenue au fluage pour une température supérieure à 80°C ainsi que de bonnes propriétés ignifuges, une faible perméabilité à l'eau, des propriétés mécaniques et de résistance aux chocs supérieures, une protection des cellules électriques contre la corrosion, une bonne résistance aux UV (Ultra Violet), une facilité de mise en oeuvre lors de l'étape de lamination du module photovoltaïque et de parfaites caractéristiques d'isolation électrique.

### Etat de l'art

On connaît à l'heure actuelle par les documents WO 2008036708, WO 2010009017, US 2009173384, WO 2008036707, EP 0998389 des encapsulants à base de polyoléfine.

Les copolymères à base éthylène sont décrits dans les documents WO 2008036708 et WO 2008036707 comme des matériaux rentrant dans la composition de films encapsulants monocouche ou multicouches. Néanmoins, une des limites principales de ce type d'encapsulants réside dans leur faible tenue thermomécanique du fait de leur absence de réticulation, combiné à une mise en oeuvre plus délicate lors de la lamination.

De même, l'utilisation des ionomères est décrit dans le document WO 95/22843 pour réaliser des films encapsulants pour modules photovoltaïques afin de résoudre les problèmes de propriétés thermomécaniques, notamment la tenue au fluage. Ces ionomères présentent également, à l'oeil nu, une bonne transparence mais, bien que les propriétés thermomécaniques soient meilleures que celles de l'éthylène-acétate de vinyle (EVA) non réticulé, la tenue au fluage n'est pas suffisante pour cette application aux modules photovoltaïques. En effet, la formation d'un réseau ionique permet au ionomère de conserver une certaine cohésion au-delà de sa température de fusion mais sans que sa tenue au fluage soit pleinement satisfaisante. Un autre problème majeur du ionomère est sa viscosité élevée aux températures habituelles de fabrication des modules photovoltaïques, généralement comprises dans la gamme allant de 120°C à 160°C, ce qui rend difficile l'étape de lamination.

Le document EP 0998389 décrit un matériau encapsulant multicouche comprenant au moins deux couches d'un copolymère éthylène-acide méthacrylique ou de ionomère avec une couche intermédiaire de polyéthylène métallocène. Ces films encapsulants peuvent présenter une tenue au fluage plus élevée que les ionomères par exemple mais ces formulations ont des propriétés optiques insuffisantes pour être utilisées en tant qu'encapsulant.

Enfin, on connaît par le document WO 09138679 une composition thermoplastique constituant l'encapsulant présentant des propriétés intéressantes liées à leurs nanostructurations, à savoir une transparence, une bonne tenue au fluage, une bonne adhésion et une facilité de mise en oeuvre. Néanmoins, un des inconvénients majeurs réside dans sa faible imperméabilité à l'eau. On notera que ce document divulgue un exemple de structure PE/encapsulant qui est réalisé pour autoriser des tests de pelage afin de mesurer l'adhésion de la couche d'encapsulant. Ainsi, le bicouche divulgué dans ce document, présentant deux couches totalement dissociable l'une de l'autre, n'est qu'un matériau de test, c'est une structure éphémère, et en aucun cas un « encapsulant de module photovoltaïque » tel que celui de la présente demande de brevet.

### Brève description de l'invention

Il a été constaté par la demanderesse, après diverses expériences et manipulations, qu'une structure particulière pouvait seule présenter des résultats optimums vis-à-vis de l'ensemble des caractéristiques recherchées pour un encapsulant de module photovoltaïque.

Ainsi, la présente invention concerne un encapsulant de module photovoltaïque, destiné à venir enrober une pile photovoltaïque, comprenant au moins deux couches adjacentes thermoplastiques formant un ensemble coeur-peau, caractérisé en ce que :
- la couche de peau consiste en un polymère greffé polyamide comprenant un tronc en polyoléfine, représentant de 50% à 95% en masse du polymère greffé polyamide, contenant un reste d'au moins un monomère insaturé (X) et au moins un greffon en polyamide, représentant de 5% à 50% en masse dudit polymère greffé polyamide, dans lequel :
   - le greffon en polyamide est attaché au tronc en polyoléfine par le reste du monomère insaturé (X) comprenant une fonction capable de réagir par une réaction de condensation avec un polyamide ayant au moins une extrémité amine et/ou au moins une extrémité acide carboxylique,
   - le reste du monomère insaturé (X) est fixé sur le tronc par greffage ou copolymérisation,
   - le tronc en polyoléfine et le greffon en polyamide étant choisis pour que ledit polymère greffé polyamide présente une température d'écoulement supérieure ou égale à 75°C et inférieure ou égale à 160°C, cette température d'écoulement étant définie comme la température la plus élevée parmi les températures de fusion et les températures de transition vitreuse du greffon polyamide et du tronc en polyoléfine ;
   la couche de coeur consiste en au moins une polyoléfine contenant un polyéthylène choisi parmi un copolymère éthylène-alphaoléfine dont la densité est comprise entre 0,865 et 0,900 (norme ASTM D 1505 ) et un copolymère d'éthylène-(méth)acrylates d'alkyle-anhydride.

Avantageusement, la couche de peau est nanostructurée.

De préférence, la masse molaire en nombre de greffon(s) polyamide est comprise dans la gamme allant de 1000 à 5000 g/mol (gramme par mole), de préférence encore comprise dans la gamme allant de 2000 à 3000 g.mol⁻¹.

D'autres caractéristiques avantageuses sont définies dans la suite :
- le au moins un greffon en polyamide comprend au moins un copolyamide.
- le tronc en polyoléfine n'a pas de température de fusion ou a une température de fusion inférieure à 110°C.
- le nombre de monomère (X) fixé sur le tronc en polyoléfine est supérieur ou égal à 1,3 et/ou inférieur ou égal à 10.
- l'épaisseur de l'encapsulant est comprise entre 10 µm et 2000 µm, l'épaisseur d'une couche de peau variant de 1 µm à 1980 µm et la couche de coeur présentant une épaisseur au moins égale à 5 µm. De préférence, l'épaisseur dudit encapsulant est comprise entre 200 µm et 600 µm.
- l'encapsulant consiste en deux couches adjacentes formant un ensemble coeur-peau ou en trois couches adjacentes formant un ensemble peau-coeur-peau où les deux couches de peau entourent la couche de coeur et sont de préférence identiques.
- selon deux variantes de réalisation, la couche de coeur consiste en un mélange de polyoléfines ou en plusieurs couches de polyoléfines différentes disposées adjacentes les unes par rapport aux autres.

Enfin, l'invention se rapporte aussi à un module photovoltaïque comprenant une structure constituée d'une association d'au moins un encapsulant et un frontsheet ou backsheet, caractérisé en ce que l'encapsulant est tel que décrit ci-dessus.

### Description des Figures annexées

La description qui va suivre est donnée uniquement à titre illustratif et non limitatif en référence aux figures annexées, dans lesquelles :
La Figure 1, déjà décrite, représente un exemple de pile photovoltaïque, les parties (a) et (b) étant des vues de ¾, la partie (a) montrant une cellule avant connexion et la partie (b) une vue après connexion de 2 cellules ; la partie (c) est une vue de dessus d'une pile photovoltaïque complète.
La Figure 2, déjà décrite, représente une coupe transversale d'un module photovoltaïque, dont le capteur photovoltaïque « classique » est encapsulé par un film d'encapsulant supérieur et un film d'encapsulant inférieur.

### Description détaillée de l'invention

S'agissant du tronc polyoléfine relativement à la partie peau, c'est un polymère comprenant comme monomère une α-oléfine. Egalement, la suite s'entend également en relation avec la partie coeur de l'encapsulant lorsque le comonomère du copolymère est une alpha-oléfine.

On préfère les α-oléfines ayant de 2 à 30 atomes de carbone.

A titre d'α-oléfine, on peut citer l'éthylène, le propylène, 1-butène, 1-pentène, 3-méthyl-1-butène, 1-hexène, 4-méthyl-1-pentène, 3-méthyl-1-pentène, 1-octène, 1-décène, 1-dodécène, 1-tétradécène, 1-hexadécène, 1-octadécène, 1-eicocène, 1-dococène, 1-tétracocène, 1-hexacocène, 1-octacocène, et 1-triacontène.

On peut également citer les cyclo-oléfines ayant de 3 à 30 atomes de carbone, préférentiellement de 3 à 20 atomes de carbone, tels que le cyclopentane, le cycloheptène, le norbornène, le 5-méthyl-2-norbomène, le tétracyclododécène, et le 2-méthyl-1,4,5,8-diméthano-1,2,3,4,4a,5,8,8a-octahydronaphthalène ; di et polyoléfines, telles que la butadiène, l'isoprène, le 4-méthyl-1,3-pentadiène, le 1,4-pentadiène, 1,5-hexadiène, 1,3-hexadiène, 1,3-octadiène, 1,4-octadiène, 1,5-octadiène, 1,6-octadiène, l'éthylidènenorbomène, le vinyle norbornène, le dicyclopentadiène, le 7-méthyl-1,6-octadiène, le 4-éthylidiène-8-méthyl-1,7-nonadiène, et le 5,9-diméthyl-1,4,8-décatriène ; les composés vinyliques aromatiques tels que le mono- ou poly alkylstyrènes (comprenant le styrène, o-méthylstyrène, m-méthylstyrène, p-méthylstyrène, o,p-diméthylstyrène, o-éthylstyrène, m-éthylstyrène et p-éthylstyrène), et les dérivés comprenant des groupes fonctionnels tels que le méthoxystyrène, l'éthoxystyrène, l'acide benzoïque vinylique, le benzoate de méthyle vinyle, l'acétate de benzyle vinyle, l'hydroxystyrène, l'o-chlorostyrène, le p-chlorostyrène, le di-vinyle benzène, le 3-phénylpropène, le 4-phénylpropène, le α-méthylstyrène, le vinyle chloride, le 1,2-difluoroéthylène, le 1,2-dichloroéthylène, le tétrafluoroéthylène, et le 3,3,3-trifluoro-1-propène.

Dans le cadre de la présente invention, le terme d'α-oléfine comprend également le styrène. On préfère le propylène et tout spécialement l'éthylène comme α-oléfine.

Cette polyoléfine peut être un copolymère constitué en au moins deux comonomères copolymérisés dans la chaîne polymère, l'un des deux comonomères dit le « premier comonomère » étant une α-oléfine et l'autre comonomère, dit « deuxième comonomère », est un monomère capable de polymériser avec le premier monomère.

A titre de deuxième comonomère, on peut citer :
- une des α-oléfines déjà citées, celle-ci étant différente du premier comonomère α-oléfine,
- les diènes tels que par exemple le 1,4-hexadiène, l'éthylidène norbornène, le butadiène
- les esters d'acides carboxyliques insaturés tels que par exemple les acrylates d'alkyle ou les méthacrylates d'alkyle regroupés sous le terme (méth)acrylates d'alkyles. Les chaînes alkyles de ces (méth)acrylates peuvent avoir jusqu'à 30 atomes de carbone. On peut citer comme chaînes alkyles le méthyle, l'éthyle, le propyl, n-butyl, sec-butyl, Isobutyl, tert-butyl, pentyl, hexyl, heptyl, octyl, 2-ethylhexyl, nonyl, decyl, undecyl, dodecyl, tridecyl, tetradecyl, pentadecyl, hexadecyl, heptadecyl, octadecyl, nonadecyl, eicosyl, hencosyl, docosyl, tricosyl, tetracosyl, pentacosyl, hexacosyl, heptacosyl, octacosyl, nonacosyl. On préfère les (méth)acrylates de méthyle, éthyle et butyle comme esters d'acide carboxylique insaturés.
- les esters vinyliques d'acide carboxyliques. A titre d'exemples d'esters vinyliques d'acide carboxylique, on peut citer l'acétate de vinyle, le versatate de vinyle, le propionate de vinyle, le butyrate de vinyle, ou le maléate de vinyle. On préfère l'acétate de vinyle comme ester vinylique d'acide carboxylique.

Avantageusement, le tronc en polyoléfine comprend au moins 50 % en moles du premier comonomère ; sa densité peut être avantageusement comprise entre 0,91 et 0,96.

Les troncs polyoléfines préférés sont constitués d'un copolymère éthylène-(méth)acrylate d'alkyle. En utilisant ce tronc polyoléfine, on obtient une excellente tenue au vieillissement à la lumière et à la température.

On ne sortirait pas du cadre de l'invention si différents « deuxièmes comonomères » étaient copolymérisés dans le tronc polyoléfine.

Selon la présente invention, le tronc polyoléfine contient au moins un reste de monomère insaturé (X) pouvant réagir sur une fonction acide et/ou amine du greffon polyamide par une réaction de condensation. Selon la définition de l'invention, le monomère insaturé (X) n'est pas un « deuxième comonomère ».

Comme monomère insaturé (X) compris sur le tronc polyoléfine, on peut citer :
- les époxydes insaturés. Parmi ceux-ci, ce sont par exemple les esters et éthers de glycidyle aliphatiques tels que l'allylglycidyléther, le vinylglycidyléther, le maléate et l'itaconate de glycidyle, l'acrylate et le méthacrylate de glycidyle. Ce sont aussi par exemple les esters et éthers de glycidyle alicycliques tels que le 2-cyclohexène-1-glycidyléther, le cyclohexène-4,5-diglycidylcarboxylate, le cyclohexène-4-glycidyl carboxylate, le 5-norbornène-2-méthyl-2-glycidyl carboxylate et l'endocis-bicyclo(2,2,1)-5-heptène-2,3-diglycidyl dicarboxylate. On préfère utiliser le méthacrylate de glycidyle comme époxyde insaturé.
- les acides carboxyliques insaturés et leurs sels, par exemple l'acide acrylique ou l'acide méthacrylique et les sels de ces mêmes acides.
- les anhydrides d'acide carboxylique. Ils peuvent être choisis par exemple parmi les anhydrides maléique, itaconique, citraconique, allylsuccinique, cyclohex-4-ène-1,2-dicarboxylique, 4-méthylènecyclohex-4-ène-1,2-dicarboxylique, bicyclo(2,2,1)hept-5-ène-2,3-dicarboxylique, et x-méthylbicyclo(2,2,1)hept-5-ène-2,2-dicarboxylique. On préfère utiliser l'anhydride maléique comme anhydride d'acide carboxylique.

Le monomère insaturé (X) est de préférence choisi parmi un anhydride d'acide carboxylique insaturé et un époxyde insaturé. En particulier, pour réaliser la condensation du greffon polyamide avec le tronc polyoléfine, dans le cas où l'extrémité réactive du greffon en polyamide est une fonction acide carboxylique, le monomère insaturé (X) est préférentiellement un époxyde insaturé. Dans le cas où l'extrémité réactive du greffon en polyamide est une fonction amine, le monomère insaturé (X) est avantageusement un époxyde insaturé et préférentiellement un anhydride d'acide carboxylique insaturé.

Selon une version avantageuse de l'invention, le nombre préféré de monomère insaturé (X) fixé en moyenne sur le tronc polyoléfine est supérieur ou égal à 1,3 et/ou préférentiellement inférieur ou égal à 10.

Ainsi, si (X) est l'anhydride maléique et la masse molaire en nombre de la polyoléfine est 15 000 g/mol, on a trouvé que ceci correspondait à une proportion d'anhydride d'au moins 0,8 % en masse de l'ensemble du tronc de polyoléfine et d'au plus 6,5%. Ces valeurs associées à la masse des greffons polyamide déterminent la proportion de polyamide et de tronc dans le polymère greffé polyamide.

Le tronc polyoléfine contenant le reste du monomère insaturé (X) est obtenu par polymérisation des monomères (premier comonomère, deuxième comonomère et éventuellement monomère insaturé (X)). On peut réaliser cette polymérisation par un procédé radicalaire à haute pression ou un procédé en solution, en réacteur autoclave ou tubulaire, ces procédés et réacteurs étant bien connus de l'homme du métier. Lorsque le monomère insaturé (X) n'est pas copolymérisé dans le tronc polyoléfine, il est greffé sur le tronc polyoléfine. Le greffage est également une opération connue en soi. La composition serait conforme à l'invention si plusieurs monomères fonctionnels (X) différents étaient copolymérisés et/ou greffés sur le tronc polyoléfine.

Selon les types et ratio de monomères, le tronc polyoléfine peut être semi-cristallin ou amorphe. Dans le cas des polyoléfines amorphes, seule la température de transition vitreuse est observée, tandis que dans celui des polyoléfines semi-cristallins une température de transition vitreuse et une température de fusion (qui sera nécessairement supérieure) sont observées. Il suffira à l'homme du métier de sélectionner les ratios de monomère et les masses moléculaires du tronc polyoléfine pour pouvoir obtenir pouvoir obtenir aisément les valeurs voulues de température de transition vitreuse, éventuellement de température de fusion ainsi que de viscosité du tronc polyoléfine.

De manière préférée, la polyoléfine a un Melt Flow Index (MFI) compris entre 3 et 400g/10min (190°C, 2,16kg, ASTM D 1238).

Les greffons polyamide peuvent être soit des homopolyamides, soit des copolyamides.

Sont notamment visés par l'expression "greffons polyamides" les homopolyamides aliphatiques qui résultent de la polycondensation :
- d'un lactame,
- ou d'un acide alpha,omega-aminocarboxylique aliphatique,
- ou d'une diamine aliphatique et d'un diacide aliphatique.

A titre d'exemples de lactame, on peut citer le caprolactame, l'oenantholactame et le lauryllactame.

A titre d'exemples d'acide alpha,omega-aminocarboxylique aliphatique, on peut citer l'acide aminocaproïque, l'acide amino-7-heptanoïque, l'acide amino-11-undécanoïque et l'acide amino-12-dodécanoïque.

A titre d'exemples de diamine aliphatique, on peut citer l'hexa-méthylènediamine, la dodécaméthylènediamine et la triméthylhexaméthylène diamine.

A titre d'exemples de diacide aliphatique, on peut citer les acides adipique, azélaïque, subérique, sébacique et dodécanedicarboxylique.

Parmi les homopolyamides aliphatiques, on peut citer, à titre d'exemple et de façon non limitative, les polyamides suivants : le polycaprolactame (PA6) ; le polyundécanamide (PA11, commercialisé par ARKEMA sous la marque Rilsan®) ; le polylauryllactame (PA12, également commercialisé par ARKEMA sous la marque Rilsan®) ; le polybutylène adipamide (PA4.6) ; le polyhexaméthylène adipamide (PA6.6) ; le polyhexaméthylène azélamide (PA6.9) ; le polyhexaméthylène sébaçamide (PA-6.10) ; le polyhexaméthylène dodécanamide (PA6.12) ; le polydécaméthylène dodécanamide (PA10.12) ; le polydécaméthylène sébaçanamide (PA10.10) et le polydodecaméthylène dodécanamide (PA12.12).

Sont également visés par l'expression "polyamides semi-cristallins" les homopolyamides cycloaliphatiques.

On peut notamment citer les homopolyamides cycloaliphatiques qui résultent de la condensation d'une diamine cycloaliphatique et d'un diacide aliphatique.

A titre d'exemple de diamine cycloaliphatique, on peut citer la 4,4'-méthylene-bis(cyclohexylamine), encore dénommée para-bis(aminocyclo-hexyl)méthane ou PACM, la 2,2'-diméthyl-4,4'méthylène-bis(cyclo-hexyl-amine), encore dénommée bis-(3-méthyl-4-aminocyclohexyl)-méthane ou BMACM.

Ainsi, parmi les homopolyamides cycloaliphatiques, on peut citer les polyamides PACM.12, résultant de la condensation du PACM avec le diacide en C12, les BMACM.10 et BMACM.12 résultant de la condensation de la BMACM avec, respectivement, les diacides aliphatiques en C10 et en C12.

Sont également visés par l'expression "greffons polyamide" les homopolyamides semi-aromatiques qui résultent de la condensation :
- d'une diamine aliphatique et d'un diacide aromatique, tel que l'acide téréphtalique (T) et l'acide isophtalique (I). Les polyamides obtenus sont alors couramment appelés "polyphtalamides" ou PPA ;
- d'une diamine aromatique, telle que la xylylènediamine, et plus particulièrement la métaxylylènediamine (MXD) et d'un diacide aliphatique.

Ainsi, et de manière non limitative, on peut citer les polyamides 6.T, 6.I, MXD.6 ou encore MXD.10.

Les greffons polyamide rentrant enjeu dans la composition selon l'invention sont préférentiellement des copolyamides. Ceux-ci résultent de la polycondensation d'au moins deux des groupes de monomères énoncés ci-dessus pour l'obtention d'homopolyamides. Le terme « monomère » dans la présente description des copolyamides doit être pris au sens d' « unité répétitive ». En effet, le cas où une unité répétitive du PA est constituée de l'association d'un diacide avec une diamine est Ceci s'explique par le fait qu'individuellement, le diacide ou la diamine n'est qu'une unité structurale, qui ne suffit pas à elle seule à polymériser pour donner un polyamide.

Ainsi, les copolyamides couvrent notamment les produits de condensation :
- d'au moins deux lactames,
- d'au moins deux acides alpha,omega-aminocarboxyliques aliphatiques,
- d'au moins un lactame et d'au moins un acide alpha,omega-aminocarboxylique aliphatique,
- d'au moins deux diamines et d'au moins deux diacides,
- d'au moins un lactame avec au moins une diamine et au moins un diacide,
- d'au moins un acide alpha,omega-aminocarboxylique aliphatique avec au moins une diamine et au moins un diacide,
la(les) diamine(s) et le(s) diacide(s) pouvant être, indépendamment l'un de l'autre, aliphatiques, cycloaliphatiques ou aromatiques.

Selon les types et ratio de monomères, les copolyamides peuvent être semi-cristallins ou amorphes. Dans le cas des copolyamides amorphes, seule la température de transition vitreuse est observée, tandis que dans celui des copolyamides semi-cristallins une température de transition vitreuse et une température de fusion (qui sera nécessairement supérieure) sont observées.

Parmi les copolyamides amorphes que l'on peut utiliser dans le cadre de l'invention, on peut citer par exemple les copolyamides contenant des monomères semi-aromatiques.

Parmi les copolyamides, on pourra également utiliser les copolyamides semi-cristallins et particulièrement ceux de type PA 6/11, PA6/12 et PA6/11/12.

Le degré de polymérisation peut varier dans de larges proportions, selon sa valeur c'est un polyamide ou un oligomère de polyamide.

Avantageusement, les greffons polyamide sont mono fonctionnels.

Pour que le greffon polyamide ait une terminaison monoamine, il suffit d'utiliser un limiteur de chaîne de formule : 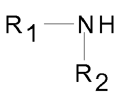 dans laquelle :
- R1 est l'hydrogène ou un groupement alkyle linéaire ou ramifié contenant jusqu'à 20 atomes de carbone,
- R2 est un groupement ayant jusqu'à 20 atomes de carbone alkyle ou alcényle linéaire ou ramifié, un radical cycloaliphatique saturé ou non, un radical aromatique ou une combinaison des précédents. Le limiteur peut être, par exemple, la laurylamine ou l'oleylamine.

Pour que le greffon polyamide ait une terminaison monoacide carboxylique, il suffit d'utiliser un limiteur de chaîne de formule R'1-COOH, R'1-CO-O-CO-R'2 ou un diacide carboxylique.

R'1 et R'2 sont des groupements alkyles linéaires ou ramifiés contenant jusqu'à 20 atomes de carbone.

Avantageusement, le greffon polyamide possède une extrémité à fonctionnalité amine. Les limiteurs monofonctionnels de polymérisation préférés sont la laurylamine et l'oléylamine.

Avantageusement, les greffons polyamide ont une masse molaire comprise entre 1000 et 5000 g/mol et de préférence entre 2000 et 3000 g/mol.

La polycondensation définie ci-dessus s'effectue selon les procédés habituellement connus, par exemple à une température comprise en général entre 200 et 300°C, sous vide ou sous atmosphère inerte, avec agitation du mélange réactionnel. La longueur de chaîne moyenne du greffon est déterminée par le rapport molaire initial entre le monomère polycondensable ou le lactame et le limiteur mono fonctionnel de polymérisation. Pour le calcul de la longueur de chaîne moyenne, on compte habituellement une molécule de limiteur de chaîne pour une chaîne de greffon.

Il suffira à l'homme du métier de sélectionner les types et ratio de monomères ainsi que choisir les masses molaires des greffons polyamide pour pouvoir obtenir aisément les valeurs voulues de température de transition vitreuse, éventuellement de température de fusion ainsi que de viscosité du greffon polyamide.

La réaction de condensation du greffon polyamide sur le tronc de polyoléfine contenant le reste de (X) s'effectue par réaction d'une fonction amine ou acide du greffon polyamide sur le reste de (X). Avantageusement, on utilise des greffons polyamide monoamine et on crée des liaisons amides ou imides en faisant réagir la fonction amine sur la fonction du reste de (X).

On réalise cette condensation de préférence à l'état fondu. Pour fabriquer la composition selon l'invention, on peut utiliser les techniques classiques de malaxage et/ou d'extrusion. Les composants de la composition sont ainsi mélangés pour former un compound qui pourra éventuellement être granulé en sortie de filière. Avantageusement, des agents de couplage sont ajoutés lors du compoundage.

Pour obtenir une composition nanostructurée, on peut ainsi mélanger le greffon polyamide et le tronc dans une extrudeuse, à une température généralement comprise entre 200 et 300 °C. Le temps de séjour moyen de la matière fondue dans l'extrudeuse peut être compris entre 5 secondes et 5 minutes, et de préférence entre 20 secondes et 1 minute. Le rendement de cette réaction de condensation est évalué par extraction sélective des greffons de polyamide libres, c'est-à-dire ceux qui n'ont pas réagi pour former le polymère greffé polyamide.

La préparation de greffons polyamide à extrémité amine ainsi que leur addition sur un tronc de polyoléfine contenant le reste de (X) est décrite dans les brevets US3976720, US3963799, US5342886 et FR2291225.

Le polymère greffé polyamide de la présente invention présente avantageusement une organisation nanostructurée. Pour obtenir ce type d'organisation, on utilisera préférentiellement par exemple des greffons présentant une masse molaire en nombre Mₙ comprise entre 1000 et 5000g/mol et plus préférentiellement entre 2000 et 3000 g/mol. On utilisera également préférentiellement 15 à 30% en masse de greffons polyamide et un nombre de monomères (X) compris entre 1,3 et 10.

La température d'écoulement du polymère greffé polyamide est définie comme la température la plus élevée parmi les températures de fusion et les températures de transition vitreuse des greffons polyamides et du tronc polyoléfine. Le tronc et les greffons sont choisis pour que la température d'écoulement du polymère greffé polyamide soit supérieure ou égale à 75°C et inférieure ou égale à 160°C, ce qui permet une température de mise en oeuvre particulièrement bien adaptée aux techniques actuelles de fabrication de panneaux solaires.

S'agissant de la couche de coeur, cette dernière est constituée en au moins une polyoléfine contenant un polyéthylène choisi parmi un copolymère comprenant au moins 50% en moles d'éthylène et d'un ou plusieurs comonomères. La couche de coeur consiste en un mélange de polyoléfines ou en plusieurs couches de polyoléfines différentes disposées adjacentes les unes par rapport aux autres.

On s'intéresse dans la suite à la définition d'un ou plusieurs comonomères. Ainsi, s'agissant du comonomère, on peut citer :
- comme précédemment énoncé, les alpha-oléfines, avantageusement celles ayant de 3 à 30 atomes de carbone. Ces alpha-oléfines peuvent être utilisées seules ou en mélange de deux ou de plus de deux. A titre d'α-oléfine, on peut citer l'éthylène, le propylène, 1-butène, 1-pentène, 3-méthyl-1-butène, 1-hexène, 4-méthyl-1-pentène, 3-méthyl-1-pentène, 1-octène, 1-décène, 1-dodécène, 1-tétradécène, 1-hexadécène, 1-octadécène, 1-eicocène, 1-dococène, 1-tétracocène, 1-hexacocène, 1-octacocène, et 1-triacontène. De préférence, les polyéthylènes comprennent une ou plusieurs alpha-oléfines comprenant 3 à 8 carbones, avec un taux d'éthylène supérieur à 50%. Les copolymères ethylène-alpha oléfines sont obtenus classiquement par des procédés connus de l'homme du métier, tels que par exemple par polymérisation Ziegler-Natta, métallocène ou organométallique comme décrit dans le document WO 2008036707. La densité de ces polymères mesurée selon la norme ASTM D 1505 peut être de 0,860 à 0,96, avantageusement de 0,860 à 0,920. Tout préférentiellement, le polyéthylène (A) ou (A1) est un polyéthylène à basse densité linéaire (PEBDL).
- les esters d'acides carboxyliques insaturés tels que par exemple les acrylates d'alkyle ou les méthacrylates d'alkyle regroupés sous le terme (méth)acrylates d'alkyles. Les chaînes alkyles de ces (méth)acrylates peuvent avoir jusqu'à 30 atomes de carbone. On peut citer comme chaînes alkyles le méthyle, l'éthyle, le propyl, n-butyl, sec-butyl, Isobutyl, tert-butyl, pentyl, hexyl, heptyl, octyl, 2-ethylhexyl, nonyl, decyl, undecyl, dodecyl, tridecyl, tetradecyl, pentadecyl, hexadecyl, heptadecyl, octadecyl, nonadecyl, eicosyl, hencosyl, docosyl, tricosyl, tetracosyl, pentacosyl, hexacosyl, heptacosyl, octacosyl, nonacosyl. On préfère les (méth)acrylates de méthyle, éthyle et butyle comme esters d'acide carboxylique insaturés. les esters d'acides carboxyliques insaturés tels que par exemple les (méth)acrylates d'alkyle, les alkyles pouvant avoir jusqu'à 24 atomes de carbone, des exemples d'acrylate ou méthacrylate d'alkyle sont notamment le méthacrylate de méthyle, l'acrylate d'éthyle, l'acrylate de n-butyle, l'acrylate d'isobutyle, l'acrylate de 2-éthylhexyle. Les copolymères ethylène-esters d'acides carboxyliques sont obtenus classiquement par des procédés connus de l'homme du métier, tels que par exemple le procédé haute pression autoclave ou tubulaire ;

- les esters vinyliques d'acide carboxylique. A titre d'exemples d'esters vinyliques d'acide carboxylique, on peut citer l'acétate de vinyle, le versatate de vinyle, le propionate de vinyle, le butyrate de vinyle, ou le maléate de vinyle. On préfère l'acétate de vinyle comme ester vinylique d'acide carboxylique.
- les diènes tels que par exemple le 1,4-hexadiène.

La polyoléfine peut comprendre aussi un monomère fonctionnel additionnel choisi parmi choisi parmi les anhydrides d'acide carboxylique insaturé, les anhydrides de diacide carboxylique insaturé, les acides carboxyliques insaturés et les époxydes insaturés. Comme monomère insaturé compris sur le tronc polyoléfine, il s'agit des :
- Les époxydes insaturés sont par exemple les esters et éthers de glycidyle aliphatiques tels que l'allylglycidyléther, le vinylglycidyléther, le maléate et l'itaconate de glycidyle, l'acrylate et le méthacrylate de glycidyle. Ce sont aussi par exemple les esters et éthers de glycidyle alicycliques tels que le 2-cyclohexène-1-glycidyléther, le cyclohexène-4,5-diglycidylcarboxylate, le cyclohexène-4-glycidyl carboxylate, le 5-norbornène-2-méthyl-2-glycidyl carboxylate et l'endocis-bicyclo(2,2,1)-5-heptène-2,3-diglycidyl dicarboxylate. On préfère utiliser le méthacrylate de glycidyle comme époxyde insaturé.
- les acides carboxyliques insaturés et leurs sels, par exemple l'acide acrylique ou l'acide méthacrylique et les sels de ces mêmes acides.
- Les anhydrides d'acide carboxylique ou de diacide carboxylique peuvent être choisis par exemple parmi les anhydrides maléique, itaconique, citraconique, allylsuccinique, cyclohex-4-ène-1,2-dicarboxylique, 4-méthylènecyclohex-4-ène-1,2-dicarboxylique, bicyclo(2,2,1)hept-5-ène-2,3-dicarboxylique, et x-méthylbicyclo(2,2,1)hept-5-ène-2,2-dicarboxylique. On préfère utiliser l'anhydride maléique comme anhydride.

Dans ce dernier cas, ces copolymères comprenant ces monomères fonctionnels sont obtenus par polymérisation des monomères (premier comonomère, deuxième comonomère éventuel, et éventuellement monomère fonctionnel). On peut réaliser cette polymérisation par un procédé radicalaire à haute pression ou un procédé en solution, en réacteur autoclave ou tubulaire, ces procédés et réacteurs étant bien connus de l'homme du métier. Lorsque le monomère fonctionnel n'est pas copolymérisé dans le tronc polyoléfine, il est greffé sur le tronc polyoléfine. Le greffage est également une opération connue en soi. La composition serait conforme à l'invention si plusieurs monomères fonctionnels différents étaient copolymérisés et/ou greffés sur le tronc polyoléfine.

De manière préférée, la polyoléfine a un Melt Flow Index (MFI) compris entre 3 et 400g/10min (190°C ; 2,16kg ; ASTM D 1238).

Des charges, en particulier minérales, peuvent être ajoutées pour améliorer la tenue thermomécanique de la composition. De façon non limitative, on donnera comme exemples la silice, l'alumine ou les carbonates de calcium ou les nanotubes de carbone. Avantageusement, on utilise des argiles modifiées ou non modifiées qui sont mélangées à l'ordre nanométrique ; ceci permet d'obtenir une composition plus transparente.

Des plastifiants pourront être ajoutés afin de faciliter la mise en oeuvre et améliorer la productivité du procédé de fabrication de la composition et des structures. On citera comme exemples les huiles minérales paraffiniques aromatiques ou naphtaléniques qui permettent également d'améliorer le pouvoir d'adhérence de la composition selon l'invention. On peut également citer comme plastifiant les phtalates, azelates, adipates, le phosphate de ticrésyle.

Des agents retardateurs de flamme pourront également être ajoutés. On pourra également ajouter des composés colorants ou azurants.

Concernant les aspects de l'invention relatifs à l'utilisation de la composition thermoplastique dans un module photovoltaïque, l'Homme de l'Art peut se référer par exemple au Handbook of Photovoltaic Science and Engineering, Wiley, 2003. En effet, la composition de l'invention peut être utilisée en tant qu'encapsulant ou encapsulant-backsheet dans un module photovoltaïque, dont on décrit la structure en relation avec les figures annexées.

Parmi la liste d'additifs ci-après, l'homme du métier saura aisément sélectionner leurs quantités afin d'obtenir les propriétés voulues de la composition, en particulier dans son application aux modules photovoltaïques.

Des agents de couplage, bien que non nécessaires, peuvent être avantageusement ajoutés afin d'améliorer le pouvoir d'adhérence de la composition lorsque celui-ci doit être particulièrement élevé. L'agent de couplage est un ingrédient non polymérique ; il peut être organique, cristallin, minéral et plus préférentiellement semi-minéral semi-organique. Parmi ceux-ci, on peut citer les titanates ou les silanes organiques, comme par exemple les monoalkyl titanates, les trichlorosilanes et les trialkoxysilanes.

Bien qu'une réticulation ne soit pas obligatoire, celle-ci est possible pour encore améliorer les propriétés thermomécaniques de l'encapsulant, en particulier lorsque la température devient très élevée. On ne sort donc pas du cadre de l'invention si des agents réticulant sont ajoutés. On peut citer comme exemples des isocyanates ou des peroxydes organiques. Cette réticulation peut également être réalisée par des techniques connues d'irradiation.

Préférentiellement, la composition ne comprend pas plus de 10% de résine tackifiante et n'en comprend préférentiellement pas. En effet, lorsque ces résines sont ajoutées au polymère greffé polyamide, la transparence de la composition et la résistance au fluage diminuent. Ces résines tackifiantes sont par exemple les colophanes et ses dérivés, les polyterpènes et ses dérivés. De manière surprenante, aucune résine tackifiante n'est nécessaire pour conférer à la composition des propriétés d'adhérence aux différents supports des modules solaires.

Dans cette application particulière de la composition aux modules photovoltaïques, le rayonnement UV étant susceptible d'entraîner un léger jaunissement de la composition utilisée en tant qu'encapsulant desdits modules, des stabilisants UV peuvent être ajoutés afin d'assurer la transparence de l'encapsulant durant sa durée de vie. Ces composés peuvent être par exemple à base de benzophénone ou de benzotriazole. On peut les ajouter dans des quantités inférieures à 10% en masse de la masse totale de la composition et préférentiellement de 0,1 à 5%.

### Obtention des formulations testées :

Des films monocouche et tricouches de 400µm ont été réalisés par extrusion de film à plat (CAST) sur une ligne d'extrusion de marque Dr COLLIN. Cette ligne d'extrusion se compose de trois extrudeuses équipées d'un profil de vis standard polyoléfine, d'un bloc de coextrusion variable (variable « feedblock »), et d'une filière porte manteaux de 250 mm (« coat hanger die »). Le bloc de coextrusion autorise la production d'un film trois couches (Couche 1 / Couche 2 / Couche 3) avec une distribution d'épaisseurs variable ( ex : 50/300/50 microns). Dans le cas particulier et non exhaustif des exemples présentés dans les brevets, les paramètres procédés ont été fixés:
- T° extrusion couche 1 et 3 : 150°C
- T° extrusion couche 2 : 200-220°C selon les polymères à extruder
- T° boite de coextrusion et filière : 180°C
- la vitesse de ligne est de 2,6 m/mn

### Matériaux employés pour former les formulations testées :

### Apolhya Solar^{®} LC3UV:

La famille Apolhya Solar^{®} est une famille de polymères commercialisée par ARKEMA qui allient les propriétés des polyamides à celles des polyoléfines grâce à l'obtention de morphologies co-continues à l'échelle manométrique. Dans le cadre des tests, il est retenu ici l'Apolhya Solar^{®} LC3UV qui est un des grades de la famille Apolhya Solar^{®} qui se caractérise par un MFI (« Melt Flow Index ») de 10 grammes/10 minutes à 230°C sous 2,16 kg commercialisé par la demanderesse. Ce produit présente un module élastique de 65 MPa à température ambiante et un point de fusion de 130°C.

### Infuse^{™} 9817.15 et Infuse^{™} 9807.15 :

La gamme Infuse^{™} est une gamme de copolymères à blocs polyoléfines commercialisée par DOW associant des blocs cristallins rigides à des blocs amorphes souples. Le grade Infuse^{™} 9817.15 est caractérisé par une densité de 0.87, une température de fusion de 120°C et un MFI de 15 g/10 min. (190°C, 2.16 kg). Le grade Infuse^{™} 9807.15 est caractérisé par une densité de 0.866, une température de fusion de 118°C et un MFI de 15 g/10' (190°C, 2.16kg).

### Lotryl^{®} 20MA08 :

La gamme Lotryl est une gamme de copolymère statistique d'éthylène et d'acrylate d'alkyle commercialisée par ARKEMA. Le Lotryl^{®} 20MA08 est un copolymère statistique d'éthylène et d'acrylate de méthyle contenant 20% en poids d'acrylate de méthyle. Il est caractérisé par un MFI de 8 g/10 min. (190°C, 2.16kg) et une température de fusion de 85°C.

### PE LA 0710 :

Le PE LA 0710 est un polyéthylène basse densité de chez TOTAL PETROCHEMICALS. Il est caractérisé par un MFI de 7.5 g/10 min. (190°C, 2.16 kg) et une température de fusion de 108°C.

### Description des films réalisés

Des films tricouches et monocouches ont été réalisés par extrusion de film à plat. Les films tricouches sont constitués de deux couches externes d'Apolhya Solar^{®} de 50 µm (micromètre) chacune et la couche centrale de 300 µm est constituée d'une polyoléfine décrite dans le paragraphe suivant. Des films monocouches de 400µm d'Apolhya Solare^{®} LC3-UV, de chacune des polyoléfines utilisées dans les films tricouches et d'alliages Apolhya Solar^{®} LC3-UV/polyoléfine (25%wt/75%wt) ont également été réalisés.

La présente invention est illustrée plus en détail par les exemples non limitatif suivant.
Exemple 1 : Le film est un film tricouches de 400µm constitué de deux couches externes d'Apolhya Solar^{®} LC3-UV de 50µm chacune et d'une couche centrale de 300µm d'Infuse^{™} 9817.15.
Exemple 2 : Le film est un film tricouches de 400µm constitué de deux couches externes d'Apolhya Solar^{®} LC3-UV de 50µm chacune et d'une couche centrale de 300µm d'Infuse^{™} 9807.15.
Exemple 3 : Le film est un film tricouches de 400µm constitué de deux couches externes d'Apolhya Solar^{®} LC3-UV de 50µm chacune et d'une couche centrale de 300µm de Lotryl^{®} 20MA08.
Exemple 4 (hors de la portée des revendications) : Le film est un film tricouches de 400µm constitué de deux couches externes d'Apolhya Solar^{®} LC3-UV de 50µm chacune et d'une couche centrale de 300µm de PE LA 0710.
Exemple comparatif 1 : Le film est un film monocouche de 400µm constitué d'Apolhya Solar^{®} LC3-UV.
Exemple comparatif 2 : Le film est un film monocouche de 400µm constitué d'Infuse^{™} 9817.15.
Exemple comparatif 3 : Le film est un film monocouche de 400µm constitué d'Infuse^{™} 9807.15.
Exemple comparatif 4 : Le film est un film monocouche de 400µm constitué de Lotryl^{®} 20MA08.
Exemple comparatif 5 : Le film est un film monocouche de 400µm constitué de PE LA 0710.
Exemple comparatif 6 : Le film est un monocouche de 400µm constitué d'un mélange d'Infuse^{™} 9817.15 et d'Apolhya Solar^{®} LC3-UV contenant 75% en masse d'Infuse^{™} 9817.15. Ce film a la même composition globale que le film de l'exemple 1. La composition est obtenue par mélange à sec de granulés avant l'extrusion du film.
Exemple comparatif 7 : Le film est un monocouche de 400µm constitué d'un mélange d'Infude PE LA0710 et d'Apolhya Solar^{®} LC3-UV contenant 75% en masse de PE LA0710. La composition est obtenue par mélange à sec de granulés avant l'extrusion du film.

### Tests réalisés sur les éprouvettes :

### Test de résistance au fluage :

Le test de fluage pratiqué ici consiste à appliquer une contrainte en traction à chaud pendant une durée déterminée puis de mesurer la déformation résiduelle à température ambiante après avoir retiré la contrainte. Ce test de fluage est effectué sur des éprouvettes de type IFC découpées dans les films. La contrainte est de 0,5 MPa. Elle est appliquée pendant 15 minutes à une température comprise entre 100°C et 120°C.

### Propriétés optiques :

Les propriétés optiques des films ont été déterminées en mesurant la transmittance dans le domaine du visible, le niveau de trouble ou haze. La transmittance des films a été évaluée entre 400 nm et 740 nm selon la norme ASTM D1003 avec un illuminant C sous 2° à l'aide d'un spectrocolorimètre CM-3610d de chez Minolta. Pour déterminer une valeur de transmittance en s'affranchissant des effets de surface, chaque film a été pressé entre 2 plaques de verre à l'aide d'un laminateur à l'échelle laboratoire de chez Penergy. Pour remonter à la transmitttance de l'encapsulant, une mesure de transmittance est effectuée sur la structure verre/film encapsulant/verre et sur une plaque de verre. La mesure sur plaque de verre seule permet de retrancher la contribution du verre à la transmittance de la structure verre/encapsulant/verre. La transmittance totale du film encapsulant est enfin déterminée en sommant les transmittances pour chaque longueur d'onde comprise entre 400 nm et 740 nm. Pour une composition thermoplastique, une transmittance supérieure ou égale à 90% est estimée satisfaisante.

Le niveau de trouble est mesuré sur des structures verre/film encapsulant/verre selon l'ASTM D 1003 avec un illuminant C sous 2°. Pour une composition thermoplastique, un niveau de trouble inférieur ou égal à 25% est estimé satisfaisant.

### Perméabilité à la vapeur d'eau:

La perméabilité à la vapeur d'eau des films est estimée selon la norme ASTM E96 méthode A à 23°C et 85% d'humidité relative et 85°C et 85% d'humidité relative.

### Adhésion sur verre :

L'adhésion sur verre a été évaluée selon le protocole suivant. Une structure Verre/film encapsulant/Backsheet est laminée 15 minutes à 150°C à l'aide du laminateur de chez Penergy. L'épaisseur du film encapsulant est de 400µm. Le backsheet est du KPE (Kynar/PET/EVA). L'adhésion à l'interface verre/encapsulant est évaluée à partir d'un test de pelage à 90° effectué à 100 mm/min sur un dynamomètre Zwyck 1445. La largeur du bras de pelage est de 15mm. La force de pelage est exprimée en N/15mm.

La composition doit satisfaire l'ensemble des tests susvisés de manière optimum pour être considérée comme satisfaisante du point de vue de ces propriétés adhésives, de ses propriétés thermomécaniques ou autrement dit de la conservation de ses propriétés mécaniques à température élevée (fluage à chaud), de ses propriétés barrières à la vapeur d'eau et enfin au regard de sa transparence. Il est bien entendu que la difficulté consiste à trouver une composition présentant de bonnes performances pour l'ensemble des propriétés testées et qu'une seule de ces propriétés à un niveau faible suffit à disqualifier cette composition.

Comme on peut le constater, la demanderesse a constaté, après ses expérimentations, que, de façon surprenante, la composition selon l'invention a parfaitement satisfait l'ensemble des tests démontrant que ses propriétés de transparence, d'adhésion sur différents supports, ses propriétés mécaniques, thermomécaniques, ignifuges et d'isolation électrique sont excellentes, ou autrement dit d'un niveau très élevé.

Les compositions selon l'invention remplissent donc les critères pour pouvoir être très avantageusement utilisée comme liant ou encapsulant dans les modules solaires.

On notera que la composition selon l'invention est définie à minima par l'association d'une couche de peau avec une couche dite de coeur telles que définies précédemment. En effet, malgré le fait que les tests pour les compositions selon l'invention ont été réalisés sur la base d'une association tricouches peau-coeur-peau, il est possible pour l'homme du métier d'extrapoler ces résultats à l'association de deux couches peau-coeur.

De la même manière, les exemples de composition selon l'invention présentent tous les mêmes épaisseurs concernant la couche de peau et celle de coeur mais il est bien entendu que l'homme du métier pourra les faire varier en fonction de l'application du module photovoltaïque et des performances de ce dernier au regard des propriétés intrinsèques de la couche et de celle de coeur, nonobstant la synergie réalisée entre ces deux couches formant l'encapsulant.

### Résultats des tests réalisés sur les éprouvettes des différentes formulations :

| | | | | **Fluage** | **Propriétés optiques** | | **perméabilité à la vapeur d'eau (g.25µm/m²/24h)** | | **Adhésion** |
|---|---|---|---|---|---|---|---|---|---|
| | couche externe (50µm) | couche interne (300µm) | couche externe (50µm) | Allongement à 110°C (sous 0.5 bars, 15min) | Transmittance (%) (400 nm - 740 nm) | Haze (%) | 23°C/85%HR | 85°C/85%HR | N/15mm |
| Exemple 1 | LC3-UV | Infuse 9817.15 | LC3-UV | 15% | 92 | 38 | 33 | -2250 | > 60 |
| Exemple 2 | LC3-UV | Infuse 9807.15 | LC3-UV | 17,50% | 93 | 32 | 33 | -2250 | > 60 |
| Exemple 3 | LC3-UV | Lotryl 20MA08 | LC3-UV | casse à 1min | 96,5 | 4 | -50 | - | > 60 |
| Exemple 4 | LC3-UV | LA 710 | LC3-UV | 200% | 91 | 36 | 9 | 1250 | > 60 |
| Exemple Comparatif 1 | LC3-UV | | | 35% | 96,5 | 2 | 87 | 5413 | > 60 |
| Exemple Comparatif 2 | infuse 9817.15 | | | 17,50% | 89 | 66 | 28 | 1883 | 0 |
| Exemple Comparatif 3 | infuse 9807.15 | | | 17,50% | 89 | 66 | 28 | 1883 | 0 |
| Exemple Comparatif 4 | Lotryl 20MA08 | | | Flue en moins d'1' | 97 | 1 | 70 | non mesurable | 0 |
| Exemple Comparatif 5 | PELA 710 | | | 300% | 88 | 60 | 7 | 1000 | 0 |
| Exemple Comparatif 6 | Alliage LC3-UV + Infuse 9817.15 (25/75) | | | 17,50% | 85 | 65 | 40 | 2530 | <20 |
| Exemple Comparatif 7 | Alliage LC3-UV + PE LA 710 (25/75) | | | 15% | 85 | 70 | 20 | 1800 | <20 |

## Revendications

1. Encapsulant de module photovoltaïque, destiné à venir enrober une pile photovoltaïque, comprenant au moins deux couches adjacentes thermoplastiques formant un ensemble coeur-peau, **caractérisé en ce que** :
• la couche de peau consiste en un polymère greffé polyamide comprenant un tronc en polyoléfine, représentant de 50% à 95% en masse du polymère greffé polyamide, contenant un reste d'au moins un monomère insaturé (X) et au moins un greffon en polyamide, représentant de 5% à 50% en masse dudit polymère greffé polyamide, dans lequel :
- le greffon en polyamide est attaché au tronc en polyoléfine par le reste du monomère insaturé (X) comprenant une fonction capable de réagir par une réaction de condensation avec un polyamide ayant au moins une extrémité amine et/ou au moins une extrémité acide carboxylique,
- le reste du monomère insaturé (X) est fixé sur le tronc par greffage ou copolymérisation,
- le tronc en polyoléfine et le greffon en polyamide étant choisis pour que ledit polymère greffé polyamide présente une température d'écoulement supérieure ou égale à 75°C et inférieure ou égale à 160°C, cette température d'écoulement étant définie comme la température la plus élevée parmi les températures de fusion et les températures de transition vitreuse du greffon polyamide et du tronc en polyoléfine ;
• la couche de coeur consiste en au moins une polyoléfine contenant un polyéthylène consistant en un copolymère choisi parmi un copolymère éthylène-alphaoléfine dont la densité est comprise entre 0,865 et 0,900 (norme ASTM D 1505) et un copolymère d'éthylène-(méth)acrylates d'alkyle-anhydride.

2. Encapsulant selon la revendication 1, **caractérisé en ce que** la couche de peau est nanostructurée.

3. Encapsulant selon la revendication 1 ou 2, **caractérisé en ce que** la masse molaire en nombre de greffon polyamide est comprise dans la gamme allant de 1000 à 5000 g/mol, de préférence comprise dans la gamme allant de 2000 à 3000 g.mol-1.

4. Encapsulant selon l'une quelconque des revendications précédentes, **caractérisé en ce que** le au moins un greffon en polyamide comprend au moins un copolyamide.

5. Encapsulant selon l'une quelconque des revendications précédentes, **caractérisé en ce que** le tronc en polyoléfine n'a pas de température de fusion ou a une température de fusion inférieure à 110°C.

6. Encapsulant selon l'une quelconque des revendications précédentes, **caractérisé en ce que** le nombre de monomère (X) fixé sur le tronc en polyoléfine est supérieur ou égal à 1,3 et/ou inférieur ou égal à 10.

7. Encapsulant selon l'une quelconque des revendications précédentes, **caractérisé en ce que** l'épaisseur dudit encapsulant est comprise entre 10 µm et 2000 µm, l'épaisseur d'une couche de peau variant de 1 µm à 1980 µm et la couche de coeur présentant une épaisseur au moins égale à 5 µm.

8. Encapsulant selon la revendication 7, **caractérisé en ce que** l'épaisseur dudit encapsulant est comprise entre 200 µm et 600 µm.

9. Encapsulant selon l'une quelconque des revendications précédentes, **caractérisé en ce qu'**il consiste en deux couches adjacentes formant un ensemble coeur-peau ou en trois couches adjacentes formant un ensemble peau-coeur-peau où les deux couches de peau entourent la couche de coeur et sont de préférence identiques.

10. Encapsulant selon l'une quelconque des revendications précédentes, **caractérisé en ce que** la couche de coeur consiste en un mélange de polyoléfines ou en plusieurs couches de polyoléfines différentes disposées adjacentes les unes par rapport aux autres.

11. Module photovoltaïque comprenant une structure constituée d'une association d'au moins un encapsulant et un frontsheet ou backsheet, **caractérisé en ce que** l'encapsulant est selon l'une quelconque des revendications précédentes.

## Patentansprüche

1. Verkapselungsmittel eines Photovoltaikmoduls, das dazu bestimmt ist, eine photovoltaische Zelle zu umhüllen, wenigstens zwei benachbarte thermoplastische Schichten umfassend, die eine Gesamtheit Kern-Mantel bilden, **dadurch gekennzeichnet, dass**:
• die Mantelschicht aus einem mit Polyamid gepfropften Polymer besteht, das eine Polyolefin-Hauptkette umfasst, welche 50 bis 95 Masse-% des mit Polyamid gepfropften Polymers repräsentiert, und einen Rest wenigstens eines ungesättigten Monomers (X) und wenigstens eine Pfropfeinheit aus Polyamid enthält, die 5 bis 50 Masse-% des mit Polyamid gepfropften Polymers repräsentieren, wobei:
- die Pfropfeinheit aus Polyamid an die Polyolefin-Hauptkette über den Rest des ungesättigten Monomers (X) gebunden ist, der eine funktionelle Gruppe umfasst, die in der Lage ist, in einer Kondensationsreaktion mit einem Polyamid zu reagieren, das wenigstens eine Aminendgruppe und/oder wenigstens eine Carboxylsäureendgruppe aufweist,
- der Rest des ungesättigten Monomers (X) durch Aufpfropfung oder Copolymerisation an der Hauptkette fixiert ist,
- die Polyolefin-Hauptkette und die Pfropfeinheit aus Polyamid so gewählt sind, dass das mit Polyamid gepfropfte Polymer eine Fließtemperatur aufweist, die höher als oder gleich 75 °C ist und niedriger als oder gleich 160 °C ist, wobei diese Fließtemperatur als die höchste Temperatur von den Schmelztemperaturen und den Glasübergangstemperaturen der Polyamid-Pfropfeinheit und der Polyolefin-Hauptkette definiert ist;
• die Kernschicht aus wenigstens einem Polyolefin besteht, das ein Polyethylen enthält, das aus einem Copolymer besteht, das aus einem Ethylen-Alphaolefin-Copolymer, dessen Dichte zwischen 0,865 und 0,900 (Norm ASTM D 1505) liegt, und einem Copolymer von Alkylanhydrid-Ethylen-(Meth)acrylaten gewählt ist.

2. Verkapselungsmittel nach Anspruch 1, **dadurch gekennzeichnet, dass** die Mantelschicht nanostrukturiert ist.

3. Verkapselungsmittel nach Anspruch 1 oder 2, **dadurch gekennzeichnet, dass** die zahlengemittelte Molmasse der Polyamid-Pfropfeinheit in dem Bereich von 1000 bis 5000 g/mol liegt, vorzugsweise in dem Bereich von 2000 bis 3000 g.mol-1.

4. Verkapselungsmittel nach einem der vorhergehenden Ansprüche, **dadurch gekennzeichnet, dass** die wenigstens eine Polyamid-Pfropfeinheit wenigstens ein Copolyamid umfasst.

5. Verkapselungsmittel nach einem der vorhergehenden Ansprüche, **dadurch gekennzeichnet, dass** die Polyolefin-Hauptkette keine Schmelztemperatur aufweist, oder eine Schmelztemperatur aufweist, die niedriger als 110 °C ist.

6. Verkapselungsmittel nach einem der vorhergehenden Ansprüche, **dadurch gekennzeichnet, dass** die Anzahl der Monomere (X), die an der Polyolefin-Hauptkette fixiert ist, größer oder gleich 1,3 und/oder kleiner oder gleich 10 ist.

7. Verkapselungsmittel nach einem der vorhergehenden Ansprüche, **dadurch gekennzeichnet, dass** die Dicke des Verkapselungsmittels zwischen 10 µm und 2000 µm liegt, wobei die Dicke einer Mantelschicht von 1 µm bis 1980 µm variiert und die Kernschicht eine Dicke aufweist, die wenigstens gleich 5 µm ist.

8. Verkapselungsmittel nach Anspruch 7, **dadurch gekennzeichnet, dass** die Dicke des Verkapselungsmittels zwischen 200 µm und 600 µm liegt.

9. Verkapselungsmittel nach einem der vorhergehenden Ansprüche, **dadurch gekennzeichnet, dass** es aus zwei benachbarten Schichten besteht, die eine Gesamtheit Kern-Mantel bilden, oder aus drei benachbarten Schichten, die eine Gesamtheit Mantel-Kern-Mantel bilden, wobei die zwei Mantelschichten die Kernschicht umgeben und vorzugsweise identisch sind.

10. Verkapselungsmittel nach einem der vorhergehenden Ansprüche, **dadurch gekennzeichnet, dass** die Kernschicht aus einer Mischung von Polyolefinen oder aus mehreren Schichten verschiedener Polyolefine, die einander benachbart angeordnet sind, besteht.

11. Photovoltaikmodul, welches eine Struktur umfasst, die aus einem Verbund wenigstens eines Verkapselungsmittels und eines Frontsheets oder Backsheets besteht, **dadurch gekennzeichnet, dass** das Verkapselungsmittel ein Verkapselungsmittel nach einem der vorhergehenden Ansprüche ist.

## Claims

1. A photovoltaic module encapsulant, intended to encase a photovoltaic cell, comprising at least two adjacent thermoplastic layers forming a core-skin assembly, **characterized in that**:
• the skin layer consists of a polyamide graft polymer comprising a polyolefin backbone, representing from 50% to 95% by weight of the polyamide graft polymer, containing a residue of at least one unsaturated monomer (X) and at least one polyamide graft, representing from 5% to 50% by weight of said polyamide graft polymer, wherein:
- the polyamide graft is attached to the polyolefin backbone by the residue of the unsaturated monomer (X) comprising a function capable of reacting via a condensation reaction with a polyamide having at least one amine end and/or at least one carboxylic acid end,
- the residue of the unsaturated monomer (X) is attached to the backbone by grafting or copolymerization,
- the polyolefin backbone and the polyamide graft being chosen so that said polyamide graft polymer has a flow temperature of greater than or equal to 75°C and less than or equal to 160°C, this flow temperature being defined as the highest temperature among the melting temperatures and glass transition temperatures of the polyamide graft and of the polyolefin backbone;
• the core layer consists of at least one polyolefin containing a polyethylene consistinf of a copolymer chosen from an ethylene/α-olefin copolymer, the density of which is between 0.865 and 0.900 (ASTM D 1505 standard), and an ethylene/alkyl(meth)acrylate/anhydride copolymer.

2. The encapsulant as claimed in claim 1, **characterized in that** the skin layer is nanostructured.

3. The encapsulant as claimed in claim 1 or 2, **characterized in that** the number-average molar mass of polyamide graft is within the range extending from 1000 to 5000 g/mol, preferably within the range extending from 2000 to 3000 g.mol⁻¹.

4. The encapsulant as claimed in any one of the preceding claims, **characterized in that** the at least one polyamide graft comprises at least one copolyamide.

5. The encapsulant as claimed in any one of the preceding claims, **characterized in that** the polyolefin backbone does not have a melting temperature or has a melting temperature below 110°C.

6. The encapsulant as claimed in any one of the preceding claims, **characterized in that** the number of monomers (X) attached to the polyolefin backbone is greater than or equal to 1.3 and/or less than or equal to 10.

7. The encapsulant as claimed in any one of the preceding claims, **characterized in that** the thickness of said encapsulant is between 10 µm and 2000 µm, the thickness of a skin layer varying from 1 µm to 1980 µm and the core layer having a thickness at least equal to 5 µm.

8. The encapsulant as claimed in claim 7, **characterized in that** the thickness of said encapsulant is between 200 µm and 600 µm.

9. The encapsulant as claimed in any one of the preceding claims, **characterized in that** it consists of two adjacent layers that form a core-skin assembly or of three adjacent layers forming a skin-core-skin assembly where the two skin layers surround the core layer and are preferably identical.

10. The encapsulant as claimed in any one of the preceding claims, **characterized in that** the core layer consists of a blend of polyolefins or of several different polyolefin layers positioned adjacent to one another.

11. A photovoltaic module comprising a structure consisting of a combination of at least one encapsulant and a frontsheet or backsheet, **characterized in that** the encapsulant is as claimed in any one of the preceding claims.
